(19) Europäisches Patentamt / European Patent Office / Office européen des brevets

(11) **EP 2 040 087 B1**

(12) **EUROPEAN PATENT SPECIFICATION**

(45) Date of publication and mention
of the grant of the patent:
**24.02.2010 Bulletin 2010/08**

(21) Application number: **07116986.6**

(22) Date of filing: **21.09.2007**

(51) Int Cl.:
**G01R 31/28** (2006.01)   **G01R 35/00** (2006.01)

(54) **Magnetic sensitivity measurement system**

System zur Messung der magnetischen Empfindlichkeit

Système de mesure de sensibilité magnétique

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(43) Date of publication of application:
**25.03.2009 Bulletin 2009/13**

(73) Proprietor: **Research In Motion Limited Waterloo, Ontario N2L 3W8 (CA)**

(72) Inventor: **Huang, Qian
Waterloo Ontario N2K 3Z7 (CA)**

(74) Representative: **Moore, Barry et al
Hanna Moore & Curley
13 Lower Lad Lane
Dublin 2 (IE)**

(56) References cited:
**EP-A- 0 508 794       FR-A- 2 796 725
US-A- 4 084 135       US-A- 4 692 697
US-A1- 2006 049 823   US-B1- 6 249 200
US-B1- 6 750 644**

## Description

Hall-effect switches may be used in a device to determine when power should be shut down to the device when the Hall-effect switch is close to a magnet. Many manufacturers provided Hall-effect switches. For the purpose of quality control in manufacturing a device utilizing a Hall-effect switch there is a need to test the sensitivity and accuracy of the switch to the strength of a specific magnetic field. The embodiments of the invention as disclosed herein address this need.

An objective technical problem with existing art is how to determine the strength of a specific magnetic field, for example that of a Hall-effect switch. Through the use of an electromagnet having a permanent magnet attached to it and powered by an adjustable DC power supply this can be achieved. This is achieved by adjusting the DC power supply until the strength of the magnetic field is indicated to the user by a detector. By moving the electromagnet and the attached permanent magnet to a probe attached to a meter such as a Gauss meter the strength of the magnetic field can be determined.

US 2006/049823 A1 discloses a probe card comprises a plurality of coils for impressing a magnetic field in changeable directions to a magnetic sensor and a group of probes for detecting an output signal of the magnetic sensor. A manufacturing cost of the magnetic sensor can be decreased.

US6249200 B1 discloses a combination of magnets provides a substantially uniform external magnetic field, in which a plate shaped magnet generates an external magnetic field and a frame shaped magnet generates another external magnetic field. The frame and plate shaped magnets are disposed proximate each other to provide, through the combination of their external magnetic fields, the substantially uniform external magnetic field in a plane disposed substantially parallel to the plate and frame shaped magnets. The size, shape and relative position of the magnets combine to produce an external magnetic field having a highly uniform magnetic field orientation over a wider area of a plane disposed proximate the magnets than heretofore available.

## BRIEF DESCRIPTION OF THE DRAWINGS

Embodiments are illustrated by way of example and without limitation in the figures of the accompanying drawings, in which like reference numerals indicate corresponding, analogous or similar elements, and in which:

Figure 1 is a plan view of an embodiment of a system for testing a Hall-effect switch;

Figure 2 is a schematic diagram of a magnetic sensitivity detector;

Figure 3 is a plan view of an electromagnet connected to a Gauss meter; and

Figure 4 is a flowchart of the process for testing the magnetic sensitivity of a Hall-effect switch.

## GENERAL

In testing Hall-effect switches a magnetic field is applied to the switch and the magnetic field is changed until the state of the output of the switch moves from "high" to "low". To provide a strong electromagnetic field requires a large amount of Direct Current (DC) which is taxing on many power supplies. To resolve this problem, an electromagnet connected to an adjustable power supply may be provided with a permanent magnet to test the switch as provided in independent system and method claims 1 and 7 respectively. This may result in significantly less DC required from the power supply. By varying the DC from the power supply, may be possible to apply "fine tuning" on the strength of the magnetic field.

## DESCRIPTION OF PREFERRED EMBODIMENTS

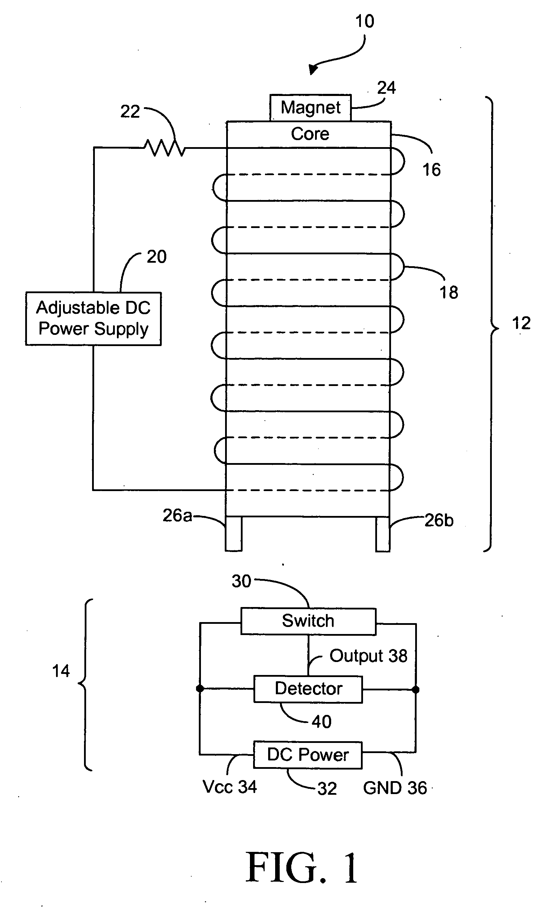

Referring now to Figure 1 a plan view of an embodiment of a system for testing a Hall-effect switch is shown generally as 10. System 10 illustrates two components; an electromagnetic coil component 12 and a Hall-effect switch component 14. Component 12 comprises a core 16, typically a ferromagnetic material, but any magnetic conductive material may be used. Core 16 is wrapped in a continuous series of wire coils 18. As one skilled in the art can appreciate electromagnets can be constructed in numerous sizes with varying materials. The magnetic field inside an electromagnet is defined as:

$$B = \mu NI/L$$

$B = \mu NI/L$
Where:

B is the magnetic flux density (magnetic induction) in the core 16, measured in Telsas where one Telsa equals 10,000 Gauss;
$\mu$ (Mu) is the permeability of core 16, measured in Henries per meter;
N is the number of turns of wire around the core 16;
I is the current in amperes; and
L is the length of the electromagnet.

An embodiment utilized by the inventor had the following characteristics. The core 16 was a Murata FSRC280060RX000T. The number of turns of wire was on the order of 400 and the diameter of the wire was approximately 0.2mm. The length of the electromagnet 12 was about 25mm.

Electromagnet 12 receives power to coils 18 via adjustable DC power supply 20. The power supply 20 utilized by the inventor had a range of 0 to 30 volts.

Resistor 22 serves as a current limiter. In the embodiment utilized by the inventor the resistor was 470 Ohm/1Watt. Attached to the top of electromagnet 12 is a permanent magnet 24.

In one embodiment, the permanent magnet utilized was a N45 sintered NdFeB (neodymium) magnet manufactured by the Hua Zing Manufacturing Company. This magnet has a residual induction of 13.7K to 11.3K Gauss.

At the base of the electromagnet 12 are non-magnetic stops 26a and 26b. Stops 26a and 26b aid the user in aligning the electromagnet 12 with Hall-effect switch 30.

Hall-effect switch component 14 comprises a Hall-effect switch 30, a DC power source 32 and a detector 40. Hall-effect switch 30 is interchangeable within Hall-effect switch component 14 so that different switches may be tested. Switch 30 may, for example, be soldered to switch component 14. In another example, switch 30 may be placed in a receptacle matching the dimension of switch 30. When switch 30 is in contact with electromagnet 12 the magnetic sensitivity of switch 30 may be tested. Switch 30 is powered by a DC power supply 32 via Vcc 34 and GND 36. In addition DC power supply 32 is connected to detector 40 through Vcc 34 and GND 36. DC power supply 32 may comprise a battery or other DC power source.

Once in contact with electromagnet 12, switch 30 through the use of output line 38 provides output on magnetic sensitivity to detector 40. Detector 40 provides visual or audio confirmation to the user when the state of switch 30 changes.

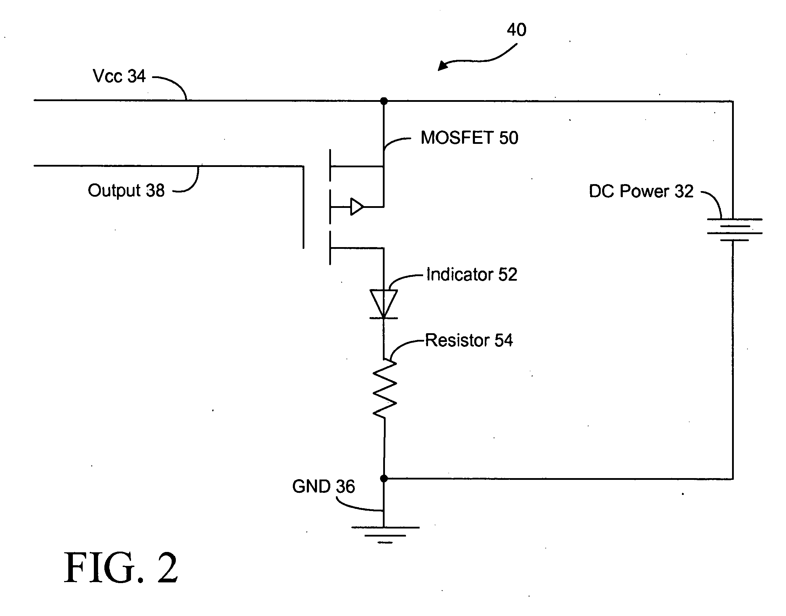

Referring now to Figure 2 a schematic diagram of a magnetic sensitivity detector is shown. Figure 2 illustrates in further detail detector 40 of Figure 1. Detector 40 receives power from DC Power 32 and is connected to ground 36 and Vcc 34 of power supply 32. Detector 40 is further connected to Hall-effect switch 30 via output 38. When the output of Hall-effect switch 30 changes to a state of "low", MOSFET 50 activates indicator 52 to advise the user. Indicator 52 may take the form of an LED or a sound chime IC. Resistor 54 serves to limit current through indicator 52.

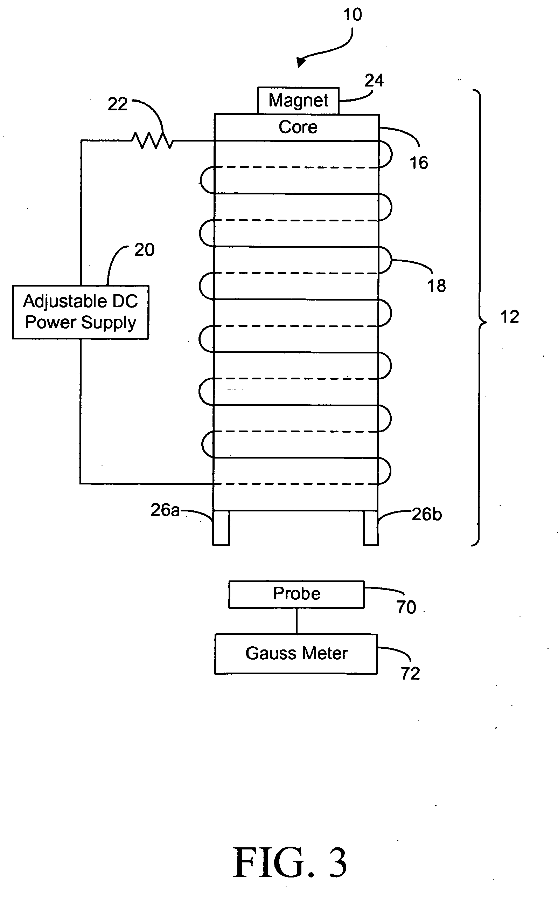

Referring now to Figure 3 a plan view of an electromagnet connected to a Gauss meter is shown. Electromagnet 12 and its associated components are identical to those of Figure 1. In use, once detector 40 has indicated to the user that switch 30 has been triggered, i.e. its output has changed to low, the user moves the electromagnet 12 to magnetic sensitivity verifier probe 70. Magnetic sensitivity verifier probe 70 may utilize a Gauss meter 72 such as the model 410 provided by Lakeshore Cryotronics Inc. Gauss meter 72 provides a reading on the magnetic sensitivity of electromagnet 12

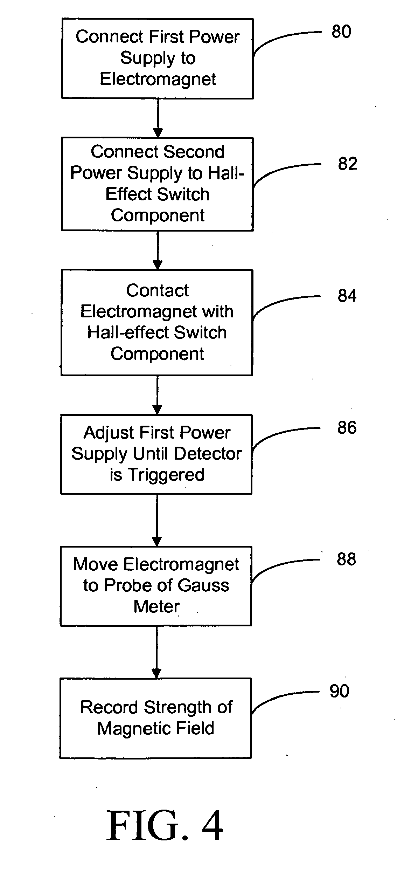

Referring now to Figure 4 a flowchart of the process for testing the strength of the magnetic field for a Hall-effect switch is shown. To aid the reader in following the steps we refer to the components of Figures 1 and 3. Beginning at step 80 electromagnet 12 is connected to adjustable DC power supply 20. At step 82, a Hall-effect switch 30 is placed in Hall-effect switch component 14. This may be done by various means, including soldering or by placing the switch in a receptacle designed for the switch. Further at step 82, a DC power supply 32, which may comprise a battery is connected to switch 30 and detector 40 of Hall-effect switch component 14. At step 84 electromagnet 12 is connected to Hall-effect switch component 14. At step 86 power supply 20 is adjusted until detector 40 is triggered. At step 88 electromagnet 12, while still connected to power supply 20 is moved to contact magnetic sensitivity verifier probe 70. Finally at step 90 the magnetic sensitivity as indicated by gauss meter 72 is recorded.

Although one example of the use of an embodiment of the present invention is for testing Hall-effect switches, use of an electromagnet with a permanent magnet as disclosed may be utilized in other fields when determining magnetic sensitivity for a specific amount of magnetic field strength is required.

Although the subject matter has been described in language specific to structural features and/or methodological acts, it is to be understood that the subject matter defined in the appended claims is not necessarily limited to the specific features or acts described above. Rather, the specific features and acts described above are disclosed as example forms of implementing the claims.

## Claims

1. A system (10) for testing the magnetic sensitivity of a Hall-effect switch (30) comprising:

   an electromagnet (12);
   a first adjustable direct current, DC, power supply (20) connected to said electromagnet (12);
   a Hall-effect switch component (14) for receiving said Hall-effect switch (30), said Hall-effect switch component (14) being connected to said electromagnet (12) and being arranged to indicate when said Hall-effect switch (30) has been triggered; and
   a probe (70) connected to a Gauss meter (72) to measure said magnetic sensitivity,

   **characterised in that** a permanent magnet (24) is attached to said electromagnet (12).

2. The system (10) of claim 1, wherein said Hall-effect switch component (14) comprises:

   means for connecting said Hall-effect switch (30) to a second DC power supply (32); and
   a detector (40) arranged to be connected to said Hall-effect switch (30) and said second DC power supply (32).

3. The system (10) of claim 2, wherein said detector (40) comprises:

a metal-oxide semiconductor field-effect transistor, MOSFET (50), connected to said second DC power supply (32) and output of said Hall-effect switch (30);
an indicator (52) connected to said MOSFET (50); and
a resistor (54) connected to said indicator (52).

4. The system (10) of claim 3, wherein said indicator (52) comprises:

a light emitting diode, LED, to indicate when said Hall-effect switch (30) has been triggered.

5. The system (10) of claim 3, wherein said indicator (52) comprises:

an integrated circuit, IC, to generate an audible signal when said Hall-effect switch (30) has been triggered.

6. The system (10) of any preceding claim, further comprising:

a current limiting resistor (22) between said first adjustable DC power supply (20) and said electromagnet (12).

7. A method for testing the magnetic sensitivity of a Hall-effect switch (30), the method comprising:

connecting a first adjustable DC power supply (20) to an electromagnet (12), said electromagnet further comprising a permanent magnet (24);
connecting a second DC power supply (32) to a Hall-effect switch component (14);
placing the Hall-effect switch (30) in the Hall-effect switch component (14);
contacting said electromagnet to said Hall-cffcct switch component (14);
adjusting said first adjustable DC power supply (20) until said Hall-effect switch component (14) indicates said Hall-effect switch (30) has been triggered; and
connecting said electromagnet (12) to a Gauss meter (72) to determine the electromagnetic sensitivity.

8. The method of claim 7, further comprising:

moving said electromagnet to a probe (70) connected to said Gauss meter (72); and

recording the magnetic sensitivity determined by said Gauss meter (72).

**Patentansprüche**

1. System (10) zum Testen der magnetischen Empfindlichkeit eines Hall-Effekt-Schalters (30), das aufweist:

einen Elektromagnet (12);
eine erste anpassbare Gleichstrom- bzw. DC(direct current)-Stromversorgung (20), die mit dem Elektromagnet (12) verbunden ist; eine Hall-Effekt-Schalter-Komponente (14) zum Aufnehmen des Hall-Effekt-Schalters (30), wobei die Hall-Effekt-Schalter-Komponente (14) mit dem Elektromagnet (12) verbunden ist und ausgebildet ist, anzuzeigen, wenn der Hall-Effekt-Schalter (30) betätigt wurde; und
einen Messfühler (70), der mit einer Gauß-Messvorrichtung (72) verbunden ist, um die magnetische Empfindlichkeit zu messen,
**dadurch gekennzeichnet, dass**
ein permanenter Magnet (24) an dem Elektromagnet (12) angebracht ist.

2. System (10) gemäß Anspruch 1, wobei die Hall-Effekt-Schalter-Komponente (14) aufweist:

Mittel zum Verbinden des Hall-Effekt-Schalters (30) mit einer zweiten DC-Stromversorgung (32); und
einen Detektor (40), der ausgebildet ist, mit dem Hall-Effekt-Schalter (30) und der zweiten DC-Stromversorgung (32) verbunden zu werden.

3. System (10) gemäß Anspruch 2, wobei der Detektor (40) aufweist:

einen Metall-Oxid-Halbleiter-Feldeffekttransistor (MOSFET - metal-oxide semiconductor field-effect transistor) (50), der mit der zweiten DC-Stromversorgung (32) und einem Ausgang des Hall-Effekt-Schalters (30) verbunden ist;
einen Indikator (52), der mit dem MOSFET (50) verbunden ist; und
einen Widerstand (54), der mit dem Indikator (52) verbunden ist.

4. System (10) gemäß Anspruch 3, wobei der Indikator (52) aufweist:

eine LED (light-emitting diode), um anzuzeigen, wenn der Hall-Effekt-Schalter (30) betätigt wurde.

5. System (10) gemäß Anspruch 3, wobei der Indikator (52) aufweist:

eine integrierte Schaltung (IC - integrated circuit), um ein hörbares Signal zu erzeugen, wenn der Hall-Effekt-Schalter (30) betätigt wurde.

6. System (10) gemäß einem vorhergehenden Anspruch, das weiter aufweist:

einen Strom-begrenzenden Widerstand (22) zwischen der ersten anpassbaren DC-Stromversorgung (20) und dem Elektromagnet (12).

7. Verfahren zum Testen der magnetischen Empfindlichkeit eines Hall-Effekt-Schalters (30), wobei das Verfahren aufweist:

Verbinden einer ersten anpassbaren DC-Stromversorgung (20) mit einem Elektromagnet (12), wobei der Elektromagnet weiter einen permanenten Magnet (24) aufweist;
Verbinden einer zweiten DC-Stromversorgung (32) mit einer Hall-Effekt-Schalter-Komponente (14);
Platzieren des Hall-Effekt-Schalters (30) in der Hall-Effekt-Schalter-Komponente (14);
in Kontakt bringen des Elektromagneten mit der Hall-Effekt-Schalter-Komponente (14);
Anpassen der ersten anpassbaren DC-Stromversorgung (20), bis die Hall-Effekt-Schalter-Komponente (14) anzeigt, dass der Hall-Effekt-Schalter (30) betätigt wurde; und
Verbinden des Elektromagneten (12) mit einer Gauß-Messvorrichtung (72), um die elektromagnetische Empfindlichkeit zu bestimmen.

8. Verfahren gemäß Anspruch 7, das weiter aufweist:

Bewegen des Elektromagneten zu einem Messfühler (70), der mit der Gauß-Messvorrichtung (72) verbunden ist; und
Aufzeichnen der magnetischen Empfindlichkeit, die von der Gauß-Messvorrichtung (72) bestimmt wird.

**Revendications**

1. Système (10) pour tester la sensibilité magnétique d'un commutateur à effet Hall (30), comprenant :

un électro-aimant (12) ;
une première alimentation en courant continu, DC, réglable (20) connectée audit électro-aimant (12) ;
un composant de commutation à effet Hall (14) pour recevoir ledit commutateur à effet Hall (30), ledit composant de commutation à effet Hall (14) étant connecté audit électro-aimant (12) et étant configuré de façon à indiquer quand ledit commutateur à effet Hall (30) a été déclenché ; et
une sonde (70) connecté à un gaussmètre (72) afin de mesurer ladite sensibilité magnétique,

**caractérisé en ce qu'**un aimant permanent (24) est fixé audit électro-aimant (12).

2. Système (10) selon la revendication 1, dans lequel ledit composant de commutation à effet Hall (14) comprend :

des moyens pour connecter ledit commutateur à effet Hall (30) à une deuxième alimentation en courant continu (32) ; et
un détecteur (40) configuré de façon à être connecté audit commutateur à effet Hall (30) et à ladite deuxième alimentation en courant continu (32).

3. Système (10) selon la revendication 2, dans lequel ledit détecteur (40) comprend :

un transistor à effet de champ métal-oxyde-semiconducteur, MOSFET (50), connecté à ladite deuxième alimentation en courant continu (32) et à la sortie dudit commutateur à effet Hall (30) ;
un indicateur (52) connecté audit transistor MOSFET (50) ; et
une résistance (54) connectée audit indicateur (52).

4. Système (10) selon la revendication 3, dans lequel ledit indicateur (52) comprend :

une diode électroluminescente, LED, pour indiquer quand ledit commutateur à effet Hall (30) a été déclenché.

5. Système (10) selon la revendication 3, dans lequel ledit indicateur (52) comprend :

un circuit intégré, IC, pour générer un signal audible lorsque ledit commutateur à effet Hall (30) a été déclenché.

6. Système (10) selon l'une quelconque des revendications précédentes, comprenant de plus :

une résistance de limitation de courant (22) entre ladite première alimentation en courant continu réglable (20) et ledit électro-aimant (12).

7. Procédé pour tester la sensibilité magnétique d'un commutateur à effet Hall (30), le procédé comprenant :

la connexion d'une première alimentation en courant continu réglable (20) à un électro-aimant (12), ledit électro-aimant comprenant de plus un aimant permanent (24) ;

la connexion d'une deuxième alimentation en courant continu (32) à un composant de commutation à effet Hall (14) ;

la disposition du commutateur à effet Hall (32) dans le composant de commutation à effet Hall (14) ;

la mise en contact dudit électro-aimant avec ledit composant de commutation à effet Hall (14) ;

le réglage de ladite première alimentation en courant continu réglable (20) jusqu'à ce que ledit composant de commutation à effet Hall (14) indique que ledit commutateur à effet Hall (30) a été déclenché ; et

la connexion dudit électro-aimant (12) à un gaussmètre (72) afin de déterminer la sensibilité électromagnétique.

8. Procédé selon la revendication 7, comprenant de plus :

le déplacement dudit électro-aimant vers une sonde (70) connectée audit gaussmètre (72) ; et l'enregistrement de la sensibilité magnétique déterminée par ledit gaussmètre (72).

10

24

22

Magnet

Core

16

20

18

Adjustable DC
Power Supply

12

26a

26b

30

Switch

Output 38

14

Detector

40

DC Power

Vcc 34

32

GND 36

# FIG. 1

FIG. 2

EP 2 040 087 B1

FIG. 3

Connect First Power Supply to Electromagnet — 80

Connect Second Power Supply to Hall-Effect Switch Component — 82

Contact Electromagnet with Hall-effect Switch Component — 84

Adjust First Power Supply Until Detector is Triggered — 86

Move Electromagnet to Probe of Gauss Meter — 88

Record Strength of Magnetic Field — 90

FIG. 4

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2006049823 A1
- US 6249200 B1